# EUROPÄISCHE PATENTSCHRIFT

(11) **EP 3 828 576 B1**
(45) Veröffentlichungstag und Bekanntmachung des Hinweises auf die Patenterteilung: **25.10.2023**
(21) Anmeldenummer: 19212164.8
(22) Anmeldetag: 28.11.2019
(51) Int. Cl.: G01R 33/48, G01R 33/58, G01R 33/565, G01R 33/561

(54) **VERFAHREN ZUR ERZEUGUNG WENIGSTENS EINES BILDDATENSATZES UND EINES REFERENZBILDDATENSATZES, DATENTRÄGER, COMPUTERPROGRAMMPRODUKT SOWIE MAGNETRESONANZANLAGE**
METHOD FOR PRODUCING AT LEAST ONE IMAGE DATA SET AND A REFERENCE IMAGE DATA SET, DATA CARRIER, COMPUTER PROGRAM PRODUCT AND MAGNETIC RESONANCE SYSTEM
PROCÉDÉ DE GÉNÉRATION D'AU MOINS UN ENSEMBLE DE DONNÉES D'IMAGE ET D'UN ENSEMBLE DE DONNÉES D'IMAGE DE RÉFÉRENCE, SUPPORT DE DONNÉES, PRODUIT PROGRAMME INFORMATIQUE AINSI QU'INSTALLATION DE RÉSONANCE MAGNÉTIQUE

(43) Veröffentlichungstag der Anmeldung: 02.06.2021
(73) Patentinhaber: Siemens Healthcare GmbH, 91052 Erlangen (DE)
(72) Erfinder: Körzdörfer, Gregor, 91058 Erlangen (DE); Nittka, Mathias, 91083 Baiersdorf (DE)

(56) Entgegenhaltungen:
- JULIANNA D. IANNI ET AL: "Trajectory Auto-Corrected image reconstruction", MAGNETIC RESONANCE IN MEDICINE., Bd. 76, Nr. 3, 12. September 2015 (2015-09-12), Seiten 757-768, XP055349313, US ISSN: 0740-3194, DOI: 10.1002/mrm.25916
- M. KRÄMER ET AL: "Intrinsic correction of system delays for radial magnetic resonance imaging", MAGNETIC RESONANCE IMAGING, Bd. 33, Nr. 4, 1. Mai 2015 (2015-05-01), Seiten 491-496, XP055705947, TARRYTOWN, NY, US ISSN: 0730-725X, DOI: 10.1016/j.mri.2015.01.005
- TOBIAS WECH ET AL: "Using self-consistency for an iterative trajectory adjustment (SCITA)", MAGNETIC RESONANCE IN MEDICINE., Bd. 73, Nr. 3, 6. April 2014 (2014-04-06), Seiten 1151-1157, XP055705952, US ISSN: 0740-3194, DOI: 10.1002/mrm.25244
- WENWEN JIANG ET AL: "Simultaneous auto-calibration and gradient delays estimation (SAGE) in non-Cartesian parallel MRI using low-rank constraints", MAGNETIC RESONANCE IN MEDICINE., Bd. 80, Nr. 5, 15. November 2018 (2018-11-15), Seiten 2006-2016, XP055705953, US ISSN: 0740-3194, DOI: 10.1002/mrm.27168
- SEBASTIAN ROSENZWEIG ET AL: "Simple auto-calibrated gradient delay estimation from few spokes using Radial Intersections (RING)", MAGNETIC RESONANCE IN MEDICINE., Bd. 81, Nr. 3, 4. November 2018 (2018-11-04), Seiten 1898-1906, XP055705955, US ISSN: 0740-3194, DOI: 10.1002/mrm.27506
- TAKAHASHI A ET AL: "Compensation of multi-dimensional selective excitation pulses using measured k-space trajectories", MAGNETIC RESONANCE IN MEDICINE, JOHN WILEY & SONS, INC, US, Bd. 34, 1. Januar 1995 (1995-01-01), Seiten 446-456, XP002590596, ISSN: 0740-3194
- CHRISTOPH BARMET ET AL: "Spatiotemporal magnetic field monitoring for MR", MAGNETIC RESONANCE IN MEDICINE, JOHN WILEY & SONS, INC, US, Bd. 60, Nr. 1, 1. Juli 2008 (2008-07-01), Seiten 187-197, XP002658387, ISSN: 0740-3194, DOI: 10.1002/MRM.21603 [gefunden am 2008-06-25]
- ADRIENNE E. CAMPBELL-WASHBURN ET AL: "Real-time distortion correction of spiral and echo planar images using the gradient system impulse response function", MAGNETIC RESONANCE IN MEDICINE., Bd. 75, Nr. 6, 25. Juni 2015 (2015-06-25), Seiten 2278-2285, XP055708313, US ISSN: 0740-3194, DOI: 10.1002/mrm.25788

## Beschreibung

Die Erfindung betrifft ein Verfahren zur Erzeugung wenigstens eines Bilddatensatzes und eines Referenzbilddatensatzes eines Untersuchungsobjektes aus wenigstens zwei Rohdatensätzen. Die Erfindung betrifft ferner ein Computerprogrammprodukt, einen Datenträger sowie eine Magnetresonanzanlage, mit der das vorgenannte Verfahren ausführbar ist.

Bei der Magnetresonanzbildgebung werden Messsequenzen zur Aufnahme von Rohdatensätzen verwendet, aus denen Bilddatensätze prozessiert werden. Mit einer Messsequenz wird der sogenannte k-Raum (z.B. definiert als der Ortsfrequenz-Raum der Spindichteverteilung) abgetastet, wobei an einer Vielzahl von Auslesepunkten Messsignale ortskodiert aufgenommen werden.

Je nach Abtastschema spricht man z.B. von einer kartesischen, spiralförmigen oder radialen Abtastung des k-Raums. Die Bahn, mit der der k-Raum dabei abgetastet wird, wird dabei als k-Raum-Trajektorie bezeichnet.

Bei einer kartesischen Abtastung liegt während des Akquisitionsfensters üblicherweise ein Lesegradient an, wodurch eine ganze k-Raum-Zeile aufgenommen werden kann. Je nach Messsequenz wird dabei Zeile für Zeile mit dazwischenliegenden Wartezeiten abgetastet. Bei einer Echo Planar Imaging (EPI)-Messsequenz werden dagegen eine Vielzahl an k-Raum-Zeilen direkt hintereinander ausgelesen.

Auch bei einer radialen Abtastung kann zwischen der Aufnahme der einzelnen Speichen, die nicht mit den bereits beschriebenen Zeilen übereinstimmen, eine Wartezeit liegen oder eine Multiechoaufnahme vorgenommen werden.

Bei den Spiraltrajektorien erfolgt die Abtastung zumindest eines Teils des k-Raums unter einem zeitlich variierenden Lesegradienten.

Das Abtastschema ist dabei grundsätzlich unabhängig von der eigentlichen Messsequenz. Eine Messsequenz ist eine vorgegebene Abfolge von Hochfrequenz(HF-)impulsen, Magnetfeldgradienten, Akquisitionsfenstern und Wartezeiten. Beispiele für derartige Messsequenzen sind eine Gradientenecho (GE)-Messsequenz, eine Spinecho (SE)-Messsequenz, Fast Low Angle SHot (FLASH), eine Fast Imaging with Steady Precession (FISP)-Messsequenz, eine True Fast Imaging with Steady Precession (TrueFISP)-Messsequenz, eine Turbo Spin Echo (TSE)-Messsequenz, eine Echo Planar Imaging (EPI)-Messsequenz, und viele mehr.

Insbesondere bei einer FLASH-, FISP- oder TrueFISP-Messsequenz kann jedes der genannten Abtastschemata verwendet werden.

Zur Ortskodierung werden Magnetfeldgradienten verwendet. Üblicherweise weist eine zur Bildgebung ausgebildete Magnetresonanzanlage drei Gradientenspulen zur Erzeugung dreier Gradientenfelder auf. Diese stehen senkrecht aufeinander, um eine Ortskodierung in allen Raumrichtungen zu ermöglichen. Durch das gezielte Anlegen von Gradienten in einer ersten und zweiten Bildrichtung, bspw. einer Leserichtung und einer Phasenkodierrichtung, werden die Auslesepunkte, also die Position der Messsignale im k-Raum, festgelegt.

Unterscheiden sich die tatsächlichen Gradientenfelder von den angenommenen, verschieben sich konsequenterweise auch die Auslesepunkte im k-Raum. Z.B. können die Gradienten eine andere als die angenommene Stärke haben oder ihre Dauer ist kürzer oder länger als vorgegeben. Dadurch werden Messsignale an anderen Positionen im k-Raum als angenommen akquiriert, wodurch im rekonstruierten Bilddatensatz Artefakte entstehen.

Derartige Abweichungen können insbesondere bei spiralförmigen k-Raum-Trajektorien oder Messsequenzen mit Multigradientenecho-Auslese wie bei einer EPI-Messsequenz zu starken Artefakten führen.

Spiraltrajektorien sind in der Realität z.B. durch Gradientenverstärker-Zeitverschiebungen, Wirbelströme und begleitende Gradientenfelder, auch concomitant gradient fields genannt, verzerrt. Diese Effekte können von Magnetresonanzanlage zu Magnetresonanzanlage unterschiedlich sein und müssen daher genau untersucht und gegebenenfalls einzeln kalibriert werden.

Es gibt eine Vielzahl von Korrekturmodellen für Spiraltrajektorien, z.B. Tan et Meyer: Estimation of k-space trajectories in spiral MRI, Magn. Reson. Med., 2009, 61(6): 1396-1404. Des Weiteren existieren auch noch generellere Methoden, die jegliche Gradientenpulse beschreiben, bspw. Duyn J.H., Yang Y., Frank J.A., van der Veen J.W.: Simple correction method for k-space trajectory deviations in MRI, J Magn. Reson., 1998, 132(1):150-3 oder Vannesjo SJ, Haeberlin M, Kasper L, Pavan M, Wilm BJ, Barmet C, Pruessmann KP: Gradient system characterization by impulse response measurements with a dynamic field camera, Magn. Reson. Med., 2013;69(2):583-93.

Weitere Korrekturverfahren werden z.B. in den Artikeln von Ianni J.D., Grissom W.A.: Trajectory Auto-Corrected Image Reconstruction, Magn. Reson. Med., 2016;76:757-68; Krämer M., Biermann J., Reichenbach J.R.: Intrinsic correction of system delays for radial magnetic resonance imaging, MRI, 2015;33:491-96; Wech T., Tran-Gia J., Bley T.A., Köstler H.: Using Self-Consistency for an Iterative Trajectory Adjustment (SCITA), Magn. Reson. Med., 2015;73:1151-157; Jiang W., Larson P.E.Z., Lustig M.: Simultaneous auto-calibration and gradient delays estimation (SAGE) in non-Cartesian parallel MRI using low-rank constraints, Magn. Reson. Med., 2017;80:2006-16; Rosenzweig S., Holme H.C.M, Uecker M.: Simple autocalibrated gradient delay estimation from few spokes using Radial Intersections (RING), Magn. Reson. Med., 2018;81:1898-1906; Takahashi A., Peters T.: Compensation of Multi-Dimensional Selective Excitation Pulses Using Measured k-Space Trajectories, Magn. Reson. Med., 1995;34:446-56; Barmet C., De Zanche N., Pruessmann K.P.: Spatiotemporal Magnetic Field Monitoring for MR, Magn. Reson. Med., 2008;60:187-97; Campbell-Washburn A.E., Xue H., Lederman R.J., Faranesh A.Z., Hansen M.S.: Real-Time Distortion Correction of Spiral and Echo Planar Images Using the Gradient System Impulse Response Function, Magn. Reson. Med., 2016;75:2278-85, beschrieben.

Es ist eine Aufgabe der vorliegenden Erfindung, ein Verfahren zur einfachen und robusten Trajektorienkorrektur insbesondere für spiralförmige k-Raum-Trajektorien zu implementieren.

Diese Aufgabe wird gelöst durch ein Verfahren zur Erzeugung wenigstens eines Bilddatensatzes und eines Referenzbilddatensatzes eines Untersuchungsobjektes aus wenigstens zwei Rohdatensätzen mit den Schritten:
- Bereitstellen eines ersten Rohdatensatzes, wobei der erste Rohdatensatz mit einer Magnetresonanzanlage aufgenommen ist und Messsignale an mehreren Auslesepunkten im k-Raum umfasst, wobei die Auslesepunkte auf einer ersten k-Raum-Trajektorie liegen,
- Bereitstellen eines zweiten Rohdatensatzes, wobei der zweite Rohdatensatz mit derselben Magnetresonanzanlage und an demselben Untersuchungsobjekt aufgenommen ist wie der erste Rohdatensatz und Messsignale an mehreren Auslesepunkten im k-Raum umfasst, wobei die Auslesepunkte auf einer zweiten, von der ersten Trajektorie unterschiedlichen k-Raum-Trajektorie liegen,
- Rekonstruktion mehrerer Bilddatensätze aus dem ersten Rohdatensatz, wobei vor der Rekonstruktion jedes Bilddatensatzes ein eigener Entzerrungskoeffizientensatz verwendet wird, wobei ein Entzerrungskoeffizientensatz eine Verschiebung der Auslesepunkte der Messsignale des ersten Rohdatensatzes im k-Raum definiert,
- Rekonstruktion eines Referenzbilddatensatzes aus dem zweiten Rohdatensatz,
- Vergleich der Bilddatensätze mit dem Referenzbilddatensatz, wobei beim Vergleich jeweils ein Ähnlichkeitswert erzeugt wird, und
- Auswahl des Bilddatensatzes mit dem größten Ähnlichkeitswert und Speichern des zugehörigen Entzerrungskoeffizentensatzes,
wobei die erste k-Raum-Trajektorie auf Gradientenabweichungen empfindlicher ist als die zweite k-Raumtrajektorie.

Der k-Raum ist dabei bekanntermaßen der abgetastete Frequenzraum. Er ist ein mathematischer Datenraum, in dem die Messsignale in Form von k-Raum-Punkten darstellbar sind. Über das Nyquist-Kriterium ist festgelegt, wie viele k-Raum-Punkte abgetastet werden müssen, um eine Rekonstruktion ohne Einfaltungsartefakte zu erhalten. Ein derartiger k-Raum wird auch vollständig genannt. Eine Unterabtastung führt dagegen zu sogenannten Einfaltungsartefakten. Es gibt aber Aufnahmearten wie bspw. parallele Bildgebung, bei der auch aus unterabgetasteten k-Räumen mit speziellen Rekonstruktionsverfahren einfaltungsartefaktfreie Bilddatensätze erhalten werden können.

Zur Abtastung des k-Raums existieren mehrere Möglichkeiten. So können sich auch bei einer kartesischen Abtastung über die Reihenfolge der Aufnahme der k-Raum-Zeilen unterschiedliche Abtastungen ergeben. Der Pfad im k-Raum, der durch die Gradientenfelder nach der oder den HF-Anregungen festgelegt wird, ist die sogenannte k-Raum-Trajektorie. Diese kann in k-Raum-Darstellungen visualisiert werden. Die k-Raum-Trajektorie zeigt also den Pfad der Aufnahme aller Messsignale, die in einen Rohdatensatz eingehen. Eine k-Raum-Trajektorie kann also auch aus Teiltrajektorien bestehen.

Die k-Raum-Punkte, die tatsächlich abgetastet wurden, werden Auslesepunkte genannt. Die Messsignale, die aufgenommen wurden, sind in einem bereits genannten Rohdatensatz abgelegt.

Eine Magnetresonanzanlage mit einer Empfangsspulenanordnung und Gradientenspulen ist dazu ausgebildet, Rohdatensätze mit unterschiedlichen Messsequenzen zu akquirieren. Dadurch können die aus einem Rohdatensatz rekonstruierten Bilddatensätze unterschiedliche Kontraste aufweisen. Auch bei Verwendung derselben Messsequenz können unterschiedliche Abtastschemata verwendet werden, wodurch sich unterschiedliche k-Raum-Trajektorien ergeben.

Es hat sich gezeigt, dass einige k-Raum-Trajektorien auf Gradientenabweichungen empfindlicher sind als andere, dergestalt, dass sie eher Abweichungen zwischen Ist- und Soll-Trajektorie aufweisen als andere. Daher werden zwei Rohdatensätze bereitgestellt, die mit unterschiedlichen k-Raum-Trajektorien aufgenommen sind. Die gegenüber Gradientenabweichungen unempfindlichere k-Raum-Trajektorie kann verwendet werden, die empfindlichere k-Raum-Trajektorie zu korrigieren.

Dies geschieht durch die gezielte Verschiebung der Auslesepunkte. Die Verschiebungsvektoren der einzelnen Auslesepunkte sind in einem Entzerrungskoeffizientensatz zusammengefasst. Mit einem Entzerrungskoeffizientensatz wird bevorzugt der erste Rohdatensatz in einen korrigierten ersten Rohdatensatz umgewandelt und dann durch eine Fouriertransformation zu einem Bilddatensatz rekonstruiert. Zu jedem Entzerrungskoeffizientensatz existiert dann ein eigener Bilddatensatz.

Diese Bilddatensätze, die alle aus dem ersten Rohdatensatz unter Verwendung jeweils eines unterschiedlichen Entzerrungskoeffizientensatzes rekonstruiert worden sind, werden dann mit einem aus dem zweiten Rohdatensatz rekonstruierten Referenzbilddatensatz verglichen. Bei dem Vergleich wird ein Ähnlichkeitswert erzeugt und der Bilddatensatz mit dem größten Ähnlichkeitswert wird weiterverwendet.

Einer der Entzerrungskoeffizientensätze kann auch eine Identitätsabbildung darstellen, also keine Verschiebung vornehmen. Ohne Gradientenabweichungen ist der unter Verwendung dieses Entzerrungskoeffizientensatzes rekonstruierte Bilddatensatz derjenige mit dem größten Ähnlichkeitswert.

Der Ähnlichkeitswert wird vorteilhafterweise über einen Kantenvergleich festgelegt. Dann wird bei der Bestimmung der Ähnlichkeit v.a. die Struktur berücksichtigt und nicht Signalintensitätsverteilungen.

Das beschriebene Verfahren kann in vier Wiederholfrequenzen eingesetzt werden:
Es kann einmalig bei der Kalibrierung eines neuen Typs Magnetresonanzanlage durchgeführt werden. Ein gefundener Entzerrungskoeffizientensatz kann dann für alle Magnetresonanzanlagen dieses Typs verwendet werden.

Es kann bei der Einrichtung jeder Magnetresonanzanlage ausgeführt werden. Dadurch können gerätespezifische Besonderheiten berücksichtigt werden.

Falls die Lage des Patienten und die damit zusammenhängenden Gradienteneinstellungen die Korrektur beeinflussen muss das Verfahren bei jedem Patienten ausgeführt werden.

Wenn aber die eigentlichen Messparameter problematisch sind, ist für jede Messsequenz eine eigene Durchführung erforderlich.

In den ersten drei Fällen wird ein Entzerrungskoeffizientensatz für zukünftige Korrekturen gespeichert.

Vorzugsweise kann als erste k-Raum-Trajektorie eine Trajektorie verwendet werden, bei der die Abtastung zumindest eines Teils des k-Raums unter einem zeitlich variierendem Lesegradienten erfolgt, insbesondere eine Spiraltrajektorie, d.h. eine spiralförmige k-Raum-Trajektorie, verwendet werden. Spiraltrajektorien sind wie eingangs beschrieben empfindlich auf Gradientenabweichungen, da die verwendeten Gradienten eine Vielzahl an Wechseln aufweisen und sich Abweichungen aufsummieren. Dementsprechend weist jeder Auslesepunkt eine unterschiedliche Verschiebung auf. Wie ebenfalls weiter oben beschrieben bezeichnet eine k-Raum-Trajektorie die Gesamtheit aller Messsignale, die zur Rekonstruktion eines Bilddatensatzes verwendet werden. Eine spiralförmige k-Raum-Trajektorie kann daher eine Spirale aufweisen. Sie kann aber auch wenigstens zwei, also mehrere, Spiralen umfassen.

Zur Erzeugung von Spiraltrajektorien werden Messsequenzen verwendet, welche mit zwei oszillierenden Gradienten ausgestattet sind.

Alternativ kann als erste k-Raum-Trajektorie ein Pfad mit wenigstens zwei verbundenen k-Raum-Linien verwendet werden. Eine k-Raum-Linie kann eine k-Raum-Zeile oder eine Speiche sein. Bevorzugt wiesen dabei jeweils zwei aufeinanderfolgende k-Raum-Linien eine unterschiedliche, insbesondere eine entgegengesetzte, Ausleserichtung auf. Eine derartige k-Raum-Trajektorie liegt u.a. bei Multigradientenecho-Messsequenzen wie einer EPI-Messsequenz vor. Auch bei derartigen Messsequenzen summieren sich Gradientenabweichungen insbesondere des Lesegradienten auf. Bevorzugt weisen die k-Raum-Linien als k-Raum-Zeilen einen Abstand in Phasenkodierrichtung auf, sind also in einer kartesischen Anordnung abgetastet. Alternativ können die k-Raum-Linien auch als Speichen bei einer radialen Abtastung erhalten werden.

Die Verbindung der k-Raum-Linien entsteht also durch das Auslesen eines Multigradientenechos. Dabei werden die Zeilen oder Speichen in einer k-Raum-Darstellung tatsächlich verbunden.

Der k-Raum kann dabei in einem einzigen Zug, als sogenannte "single-shot"-Abtastung, oder segmentiert abgetastet werden.

Je mehr k-Raum-Linien in einem Zug aufgenommen werden desto größer ist die Anfälligkeit in Bezug auf Gradientenabweichungen.

Des Weiteren sind andere komplizierte Trajektorien denkbar, wie Rosette (https://www.ncbi.nlm.nih.gov/pmc/articles/PMC2746043/) oder grundsätzlich Trajektorien, bei denen sich die Ausleserichtung ändert.

Vorteilhafterweise kann als zweite k-Raum-Trajektorie eine kartesische Verteilung der Auslesepunkte verwendet werden. Diese kann bevorzugt mit einer Messsequenz aufgenommen werden, bei der nur wenige oder bevorzugt ein einziges Gradientenecho aufgenommen wird. Die k-Raum-Trajektorie besteht dann aus einzelnen, unverbundenen k-Raum-Zeilen oder aus Blöcken von wenigen, unverbundenen Zeilen. Bei kartesischen Trajektorien ist die durch Gradientenabweichungen verursachte Verschiebung im k-Raum typischerweise für jede Zeile exakt gleich, da alle in die gleiche Richtung zeigen. Wenige Gradientenechos bedeutet weniger Gradientenechos als beim ersten Rohdatensatz, insbesondere maximal 10 Gradientenechos. Vorteilhafterweise wird ein einziges Gradientenecho in einem Zug akquiriert.

Unter das Merkmal der wenigen oder des einzigen Gradientenechos fallen auch alle bildgebenden Spinecho- und Misch-Messsequenzen. Auch bei Spinecho-Messsequenzen wird gleichzeitig zum Spinecho mittels eines Lese-Dephasiergradienten und den folgenden Lesegradienten ein Gradientenecho erzeugt.

Vorzugsweise werden zur Rekonstruktion des Referenzbilddatensatzes nur eines der ersten Gradientenechosignale oder die ersten Gradientenechosignale verwendet. Wird bei der Aufnahme der Rohdaten eine Turbospinecho-Messsequenz zusammen mit einem 2-point-Dixon-Verfahren kombiniert, so dient das jeweils zweite Gradientenecho zur Erzeugung eines zweiten Bilddatensatzes. Derartige Gradientenechos sind aber unerheblich für den Referenzbilddatensatz, der vorteilhafterweise aus den jeweils ersten Gradientenechos rekonstruiert wird.

Alternativ kann als zweite k-Raum-Trajektorie ein Pfad mit unverbundenen Speichen oder wenigen verbundenen Speichen verwendet werden. Auch eine radiale Abtastung mit einem einzigen oder wenigen Gradientenechosignalen ist also möglich. Auch hier sind die wenigen Gradientenechosignale weniger Gradientenechosignale als beim ersten Rohdatensatz, bevorzugt maximal 10 Gadientenechosignale.

Vorzugsweise kann bei der Erzeugung zumindest eines Entzerrungskoeffizientensatzes ein Modell der Gradientenabweichung bei der Aufnahme des ersten Rohdatensatzes verwendet werden. In das Modell können alle Ursachen für Abweichungen einflie-ßen, die bekannt sind. Dafür ist es nicht notwendig, die Abweichungen exakt zu kennen, ansonsten könnten sie von vorneherein bei der Erstellung der Messparameter berücksichtigt werden.

Es kann aber einfließen, ob die Gradientenmomente tendenziell zu groß oder zu klein sind, ob die Abweichung ausschließlich oder stärker in einer bestimmten Richtung vorliegt, wie sich Wirbelströme auswirken, etc. Es können also im Hinblick auf die erkannten Abweichungen speziell angepasste Entzerrungskoeffizientensätze erzeugt werden.

Ist beispielsweise bekannt, dass die Gradientenabweichungen eine Verschiebung nur in Leserichtung bewirken, verschiebt ein Entzerrungskoeffizientensatz die Auslesepunkte nur in Leserichtung. Da die Stärke der Verschiebung nicht bekannt ist werden verschieden starke Verschiebungen "ausprobiert" und unter Verwendung eines Entzerrungskoeffizientensatzes jeweils ein Bilddatensatz erzeugt.

Weiterhin können im Zentrum des k-Raums kleinere Verschiebungen vorgesehen sein als weiter außen, da die Gradientenstärken im Zentrum kleiner sind. Das gesamte Vorwissen über die Gradienten kann in die Entzerrungskoeffizientensätze gepackt werden, um eine Entzerrung mit möglichst wenigen Entzerrungskoeffizientensätzen zu erreichen.

Alternativ oder zusätzlich kann zumindest ein Entzerrungskoeffizientensatz mit Zufallszahlen erzeugt werden. In einer ersten Ausgestaltung werden die Verschiebungen für jeden Entzerrungskoeffizientensatz alleine mit Zufallszahlen erzeugt. Dies ist ein Art brute force-Angriff. Dieses Vorgehen kann immer angewendet werden, da es kein Vorwissen voraussetzt. Es ist allerdings meistens ineffizient.

In einer zweiten Alternative kann die Verwendung der Zufallszahlen mit der Anwendung von Vorwissen, beispielsweise dem Modell der Gradientenabweichung bei der Aufnahme des ersten Rohdatensatzes, kombiniert werden. Dabei können Modellfehler abgefangen werden ohne dass sozusagen blind nach Verschiebewerten gegriffen wird. Eine Kombination kann beispielsweise dadurch erhalten werden, dass Grenzwerte für die Zufallszahlen ortsabhängig vorgegeben werden. Wie weiter oben beschrieben können die Gradientenabweichungen am Rand größer sein. Dort sind die Grenzwerte für die Zufallszahlen ebenfalls höher. Zusätzlich oder alternativ werden mit den Zufallszahlen nur Verschiebungen für Richtungen ermittelt, in denen eine Abweichung erwartet wird. Man kann also jedes Modell mit Zufallszahlen kombinieren, um die Modelle robuster gegen unberücksichtigte Einflüsse zu halten.

Vorteilhafterweise kann eine maximale Verschiebung für die Auslesepunkte der Messsignale vorgegeben werden. Dabei geht es darum, die Verschiebungen in einem physikalisch sinnvollen Bereich zu halten. Zwar werden bereits bei der Verwendung von Zufallszahlen Grenzwerte für die Zahlen als solche vorgegeben. Man kann aber die sich daraus ergebende Verschiebung mit zusätzlichen Bedingungen versehen. Beispielsweise kann vorgegeben werden, dass zwei auf der k-Raum-Trajektorie nebeneinanderliegende Auslesepunkte nicht ihren Platz vertauschen. Auch dabei geht es darum, die Anzahl der verwendeten Entzerrungskoeffizientensätze auf eine geringst mögliche Anzahl zu beschränken.

Bevorzugt können als erster Rohdatensatz mehrere Teildatensätze bereitgestellt werden, wobei die Teildatensätze mit wenigstens einem unterschiedlichen Messparameter bestehend aus der Gruppe Flipwinkel des Anregungsimpulses und/oder Repetitionszeit aufgenommen sind. Eine besonders wertvolle Anwendung des beschriebenen Verfahrens erfolgt beim Magnetic Resonance Fingerprinting, kurz MRF oder MR Fingerprinting. Beim MR Fingerprinting werden direkt nacheinander Bilddatensätze mit unterschiedlichen Messparametern akquiriert, um Signalverlaufskurven zu erzeugen, die von mehreren Gewebe- und Geräteparametern beeinflusst sind, bspw. von der T1-Relaxationszeit und/oder der T2-Relaxationszeit und/oder der HF-Impulsstärke B1 oder der Grundfeldstärke B0.

Jede Signalverlaufskurve wird mit den in einem sogenannten Dictionary abgespeicherten Signalverlaufskurven verglichen und so die Gewebe- und Geräteparameter ermittelt. Jede Signalverlaufskurve wird aus einer Vielzahl von MRF-Bilddatensätzen erhalten, und zwar üblicherweise für jedes Bildelement eine Signalverlaufskurve.

Um die Vielzahl an MRF-Bilddatensätzen, und zwar in der Größenordnung von mehreren hundert, in einer überschaubaren Zeit aufnehmen zu können ist es bekannt, Spiraltrajektorien bei der Aufnahme eines MRF-Bilddatensatzes zu verwenden. Dabei kann es vorkommen, dass ein MRF-Bilddatensatz achtundvierzigfach unterabgetastet ist. Um bei der Erzeugung eines ersten Rohdatensatzes die Unterabtastung zu verringern kann aus mehreren Spiralen eine spiralförmige k-Raum-Trajektorie gebildet werden. Dazu müssen die Spiralen zumindest teilweise unterschiedliche Auslesepunkte aufweisen, ansonsten würde lediglich eine Mittelung vorliegen. Beispielsweise können die Spiralen um einen Winkel gegeneinander verdreht sein. Bei vier Spiralen kann jeweils eine 90°-Drehung vorliegen.

Eine Spirale wird also zur Erzeugung eines MRF-Bilddatensatzes verwendet und mehrere, bspw. vier, Spiralen bilden einen ersten Rohdatensatz zur Erzeugung eines Bilddatensatzes. Dadurch können die Spiralen nicht nur für ein MRF-Verfahren verwendet werden sondern gleichzeitig für eine vorherige Entzerrung.

Damit stellt ein MRF-Rohdatensatz, also die auf einer Spirale liegenden Messsignale, der verwendet wird, einen MRF-Bilddatensatz zu rekonstruieren, einen Teildatensatz eines ersten Rohdatensatzes dar.

Bei der Bereitstellung oder Aufnahme der MRF-Bilddatensätze kommt daher als zusätzliche Aufgabe hinzu, eine Korrektur für einen oder mehrere erste Rohdatensätze zu erhalten, der die Messzeit nicht oder zumindest nicht wesentlich verlängert.

Zur Lösung dieses Problems ist daher vorgesehen, bei der Aufnahme der MRF-Bilddatensätze einen Teil mit einer Spiralabtastung und einen Teil mit einer kartesischen Abtastung aufzunehmen. Dabei ist das eingangs beschriebene Verfahren dahingehend zu ergänzen, dass Messparameter während der Messung variiert werden.

Zusätzlich kann auch die Messsequenz variiert werden, wobei beim MR Fingerprinting die Magnetisierung von Messsequenz zu Messsequenz durch direktes Aufeinanderfolgen der Messsequenzen übernommen wird.

Ein derartiger aufgenommener MRF-Datensatz besteht dann aus mehreren ersten Rohdatensätzen und wenigstens einem zweiten Rohdatensatz. Jeder der ersten Rohdatensätze kann aus mehreren Teildatensätzen bestehen. Dann werden aus ihm mehrere MRF-Bilddatensätze erzeugt. Davon zu unterscheiden ist aber das Vorgehen zum Erhalt einer korrigierten k-Raum-Trajektorie. Dabei wird ein ganzer erster Rohdatensatz trotz der unterschiedlichen Messparameter herangezogen. Im ganzen ersten Rohdatensatz werden die Auslesepunkte mittels eines Entzerrungskoeffizientensatzes verschoben und daraus - für jeden Entzerrungskoeffizientensatz - ein einziger Bilddatensatz erzeugt. Hat man diejenige k-Raum-Trajektorie gefunden, bei der der Ähnlichkeitswert maximal ist, kann sie verwendet werden, um die mehreren MRF-Bilddatensätze aus der einzigen k-Raum-Spiraltrajektorie zu rekonstruieren.

Es können dabei zwar sowohl die Bilddatensätze aus der k-Raum-Spiraltrajektorie als auch die MRF-Bilddatensätze aus den Spiralen unterabgetastet sein. Die MRF-Bilddatensätze sind aber wesentlich stärker unterabgetastet. Durch die Verwendung der ersten Rohdatensätze statt der einzelnen Spiralen wird erst die Berechnung sinnvoller Ähnlichkeitswerte möglich. Entzerrungskoeffizientensätze können für jede Art von k-Raum-Trajektorie bereit gestellt werden, allerdings besteht bei zu stark unterabgetasteten Rohdatensätzen das Problem, dass die daraus rekonstruierten Bilddatensätze zu starke Einfaltungsartefakte aufweisen. Dann können keine sinnvollen Ähnlichkeitswerte mehr mit einem Referenzbilddatensatz erstellt werden.

Vorzugsweise können mehrere erste Rohdatensätze bereitgestellt werden und für einen ersten Rohdatensatz ein Entzerrungskoeffizientensatz ausgewählt werden, der für alle ersten Rohdatensätze oder für Teildatensätze der ersten Rohdatensätze verwendet wird. Dies ist ebenfalls eine Anwendung beim MRF-Fingerprinting, insbesondere bei Verwendung unterschiedlicher Messsequenzen mit Spiralabtastung. Es wird dann für einen Bilddatensatz derjenige Entzerrungskoeffizientensatz ermittelt, der zum größten Ähnlichkeitswert führt. Dieser kann dann auf andere erste Rohdatensätze angewendet werden, um diese ebenfalls zu korrigieren.

Dieses Vorgehen stellt insofern eine Abwandlung dar, als dass bislang ein Abspeichern des Entzerrungskoeffizientensatzes unerheblich war, da er nicht zwingend weiter verwendet wurde. Es konnte z.B. auch der entzerrte Rohdatensatz, also der erste Rohdatensatz mit bereits angewendeten Verschiebungen, abgespeichert werden.

Vorzugsweise kann nach der Rekonstruktion wenigstens zweier Bilddatensätze aus dem ersten Rohdatensatz unter Verwendung zweier unterschiedlicher Entzerrungskoeffizientensätze die sich ergebenden Ähnlichkeitswerte bei der Erzeugung eines dritten Entzerrungskoeffizientensatzes berücksichtigt werden. Mit anderen Worten kann die Erzeugung der Entzerrungskoeffizientensätze und der Bilddatensätze iterativ geschehen. Man bewertet anhand der Bilddatensätze, welche Entzerrungskoeffizientensätze eine Verbesserung herstellen oder welche eine größere Verbesserung bewirken und versucht diese dann weiter zu verbessern. Beispielsweise kann ein erster Entzerrungskoeffizientensatz Verschiebungen im Zentrum des k-Raums vornehmen und ein zweiter Verschiebungen in den Außenbereichen des k-Raums. Je nachdem, welcher der aus dem ersten Rohdatensatz unter Verwendung des ersten und des zweiten Entzerrungskoeffizientensatzes erzeugten Bilddatensätze einen größeren Ähnlichkeitswert aufweist, wird der Entzerrungskoeffizientensatz abgewandelt, der dem Bilddatensatz mit dem größeren Ähnlichkeitswert zugeordnet ist.

Bevorzugt kann der erste Rohdatensatz mit einer ersten Messsequenz aufgenommen sein und die Messsequenz zur Aufnahme des zweiten Rohdatensatzes so ausgewählt werden, dass aus dem ersten und dem zweiten Rohdatensatz rekonstruierten Bilddatensätze möglichst gleiche Kontraste aufweisen. Die Gradientenabweichungen bewirken in einem aus einem ersten Rohdatensatz rekonstruierten Bilddatensatz eine Veränderung der Konturen. Der Entzerrungskoeffizientensatz soll diese Veränderung rückgängig machen. Ein Vergleich bspw. der Kanten in einem Bilddatensatz und im Referenzbilddatensatz zeigt dann, wie gut die Entzerrung funktioniert hat. Insbesondere können der erste Rohdatensatz und der zweite Rohdatensatz mit derselben Messsequenz, aber unterschiedlichen k-Raum-Trajektorien, aufgenommen sein.

Vorteilhafterweise kann ein Entzerrungskoeffizientensatz zusätzlich eine Phasenverschiebung definieren. Eine Phasenverschiebung kann durch lokale off-Resonanzen, d.h. durch vom erwarteten B0 verschiedene lokale Magnetfeldstärken entstehen. Diese sind durch Inhomogenitäten des Grundmagnetfelds der Magnetresonanzanlage oder durch Suszeptibilitätsunterschiede von Geweben des Patienten bedingt. Die Phase ist ein weiterer Parameter, der im Entzerrungskoeffizientensatz vorhanden ist. Damit wird die Entzerrung etwas aufwändiger, am Ende aber noch besser.

Daneben betrifft die Erfindung ein Verfahren zum Trainieren eines künstlichen, neuronalen Netzwerkes, umfassend die Schritte:
- Empfangen von Eingangs-Trainingsdaten, wobei die Eingangs-Trainingsdaten der erste Rohdatensatz nach einem der vorangehenden Ansprüche ist,
- Empfangen von Ausgangs-Trainingsdaten, wobei die Ausgangs-Trainingsdaten der zweite Rohdatensatz nach einem der vorangehenden Ansprüche ist,
- Trainieren des neuronalen Netzwerkes mit den Eingangs- und Ausgangstrainingsdaten, insbesondere durch Backpropagation,
- Bereitstellen des trainierten neuronalen Netzwerkes.

Beim MRF entstehen mehrere erste Rohdatensätze. Für jeden von diesen kann zum Trainieren des künstlichen, neuronalen Netzwerkes ein optimaler Entzerrungskoeffizientensatz wie weiter oben beschrieben ermittelt werden. Dann können diese Daten auch verwendet werden, ein neuronales Netzwerk zu trainieren.

Mit dem trainierten neuronalen Netzwerk ist es möglich, statt des festen Einbaus von Rohdatensätzen mit einer zweiten k-Raum-Trajektorie, insbesondere mit einer kartesischen Abtastung, zur Erzeugung von Referenzbilddatensätzen diese nur zum Trainieren des künstlichen, neuronalen Netzwerkes zu verwenden und dann wieder MRF-Datensätze zu verwenden, bei denen nur k-Raum-Spiraltrajektorien bei der Abtastung des k-Raums verwendet wurden.

Daneben betrifft die Erfindung ein Verfahren zur Erzeugung wenigstens eines Bilddatensatzes unter Verwendung eines trainierten neuronalen Netzwerkes wie beschrieben, mit den Schritten:
- Bereitstellen eines ersten Rohdatensatzes, wobei der erste Rohdatensatz mit einer Magnetresonanzanlage aufgenommen ist und Messsignale an mehreren Auslesepunkten im k-Raum umfasst, wobei die Auslesepunkte auf einer ersten k-Raum Trajektorie liegen,
- Anwenden des trainierten neuronalen Netzwerkes wie beschrieben auf den ersten Rohdatensatz, wodurch ein korrigierter erster Rohdatensatz erzeugt wird, und
- Rekonstruktion eines Bilddatensatzes aus dem korrigierten ersten Rohdatensatz.

Ist das neuronale Netzwerk trainiert, kann es für die Entzerrung der ersten Rohdatensätze verwendet werden. Im Rahmen von MRF können wie beschrieben aus einem korrigierten oder entzerrten ersten Rohdatensatz mehrere MRF-Bilddatensätze rekonstruiert werden.

Des Weiteren betrifft die vorliegende Erfindung ein Computerprogrammprodukt, welches man in einen Speicher einer programmierbaren Steuereinrichtung bzw. einer Recheneinheit einer Magnetresonanzanlage laden kann. Mit diesem Computerprogrammprodukt können alle oder verschiedene vorab beschriebene Ausführungsformen des erfindungsgemäßen Verfahrens ausgeführt werden, wenn das Computerprogrammprodukt in der Steuereinrichtung läuft. Dabei benötigt das Computerprogrammprodukt eventuell Programmmittel, z.B. Bibliotheken und Hilfsfunktionen, um die entsprechenden Ausführungsformen des Verfahrens zu realisieren. Mit anderen Worten soll mit dem auf das Computerprogrammprodukt gerichteten Anspruch insbesondere eine Software unter Schutz gestellt werden, mit welcher eine der oben beschriebenen Ausführungsformen des erfindungsgemäßen Verfahrens ausgeführt werden kann bzw. welche diese Ausführungsform ausführt. Dabei kann es sich bei der Software um einen Quellcode (z.B. C++), der noch compiliert und gebunden oder der nur interpretiert werden muss, oder um einen ausführbaren Softwarecode handeln, der zur Ausführung nur noch in die entsprechende Recheneinheit bzw. Steuereinrichtung zu laden ist.

Daneben betrifft die Erfindung einen Datenträger für eine Steuerungseinrichtung zur Steuerung eines Rechners, insbesondere einer Datenerzeugungseinheit einer Magnetresonanzanlage und/oder einer Auswerteeinheit, mit Daten zum Durchführen des beschriebenen Verfahrens. Vorteilhafterweise kann die Datenerzeugungseinheit eine Bilderzeugungseinheit sein. Die Auswerteeinheit kann Bestandteil der Magnetresonanzanlage oder eine externe Einheit sein. Dann kann auch der Datenträger ein ständig zugänglicher Speicher der Magnetresonanzanlage sein. Dafür muss er nicht in der Steuerungseinrichtung der Magnetresonanzanlage verbaut sein, er kann auch als Speicherdienst oder Cloud-Server ausgebildet sein.

Die Implementierung der vorgenannten Verfahren in der Steuervorrichtung kann dabei als Software oder aber auch als (fest verdrahtete) Hardware erfolgen.

Daneben betrifft die Erfindung eine Magnetresonanzanlage mit einer Steuerungseinrichtung. Die Magnetresonanzanlage zeichnet sich dadurch aus, dass die Steuerungseinrichtung zur Durchführung des Verfahrens wie beschrieben ausgebildet ist.

Weitere vorteilhafte Ausgestaltungen der erfindungsgemäßen Magnetresonanzanlage korrespondieren zu entsprechenden Ausgestaltungen des erfindungsgemäßen Verfahrens. Zur Vermeidung unnötiger Wiederholungen wird somit auf die entsprechenden Verfahrensmerkmale und deren Vorteile verwiesen.

Weitere Vorteile, Merkmale und Besonderheiten der vorliegenden Erfindung ergeben sich aus der nachfolgenden Beschreibung vorteilhafter Ausgestaltungen der Erfindung.

Dabei zeigen:
- Fig. 1: eine Magnetresonanzanlage,
- Fig. 2: ein TrueFISP-Sequenzdiagramm,
- Fig. 3: eine spiralförmige k-Raum-Trajektorie,
- Fig. 4: eine kartesische k-Raum-Trajektorie mit unverbundenen k-Raum-Zeilen,
- Fig. 5: eine kartesische k-Raum-Trajektorie mit verbundenen k-Raum-Zeilen,
- Fig. 6: ein MRF-Verfahren mit mehreren Messsequenzen,
- Fig. 7: einen korrigierten ersten Rohdatensatz,
- Fig. 8: eine erste Ausführungsform eines Verfahrens zur Erzeugung eines Bilddatensatzes, und
- Fig. 9: eine zweite Ausführungsform eines Verfahrens zur Erzeugung eines Bilddatensatzes.

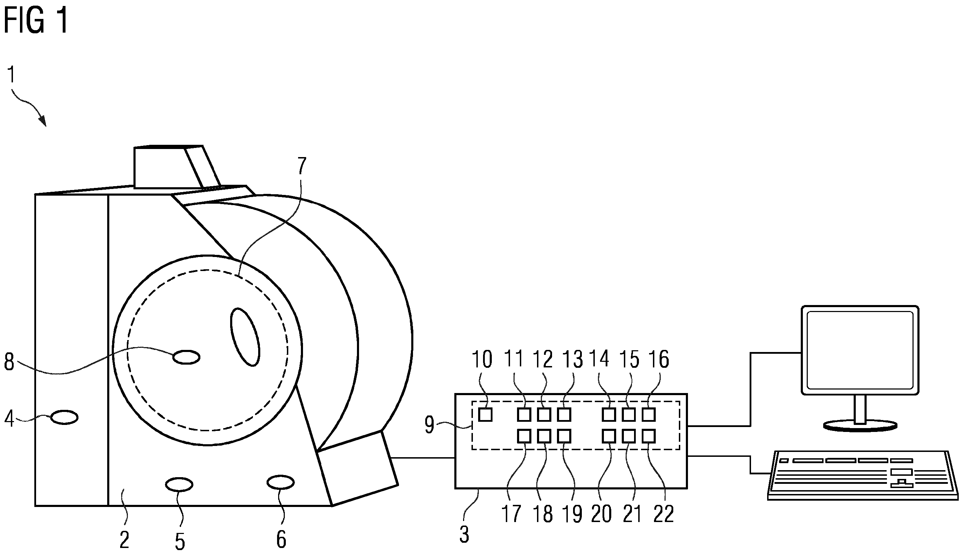

Fig. 1 zeigt eine Magnetresonanzanlage 1 mit einem Scanner 2 und einer Steuerungseinrichtung 3. Der Scanner 2 weist drei Gradientenspulen 4, 5 und 6 zur Erzeugung von Gradientenfeldern auf. Am Scanner 2 ist weiterhin eine Sendespulenanordnung 7 vorhanden. Die Sendespulenanordnung 7 kann als Ganzkörperspule ausgestaltet sein. Es kann sich bei der Sendespulenanordnung 7 aber auch um ein Sendespulenarray handeln.

Die Sendespulenanordnung 7 kann auch zum Signalempfang verwendet werden. Es ist aber zur Steigerung des Signal-Rausch-Verhältnisses SNR auch bekannt, Lokalspulen zu verwenden. Insbesondere kann zur Durchführung von paralleler Bildgebung als Empfangsspulenanordnung 8 ein Spulenarray eingesetzt werden. Mit einem Spulenarray kann die Messzeit verkürzt werden.

Die Steuerungseinrichtung 3 der Magnetresonanzanlage 1 weist einen Datenträger 9 auf, auf dem ein Computerprogrammprodukt 10 zur Durchführung des beschriebenen Verfahrens abgelegt ist. Auch können auf dem Datenträger 9 eine FISP-Messsequenz 11 mit spiraler k-Raum-Abtastung, eine FLASH-Messsequenz 12 mit spiraler k-Raum-Abtastung, eine TrueFISP-Messsequenz 13 mit spiraler k-Raum-Abtastung und eine FISP-Messsequenz 14 mit kartesischer k-Raum-Abtastung unverbundener Zeilen abgelegt sein.

Weiterhin können auch eine EPI-Messsequenz 15 mit kartesischer k-Raum-Abtastung und eine FLASH-Messsequenz 16 mit kartesischer k-Raum-Abtastung abgespeichert sein.

Die FISP-Messsequenz 11 kann zur Aufnahme eines ersten Rohdatensatzes 17 eingesetzt werden. Mit der FLASH-Messsequenz 12 kann ein erster Rohdatensatz 18 akquiriert werden. Die TrueFISP-Messsequenz 13 kann zur Akquisition eines ersten Rohdatensatzes 19 verwendet werden. Ein zweiter Rohdatensatz 20 kann dagegen mit der FISP-Messsequenz 14 erhalten werden.

Ebenso können mit der EPI-Messsequenz 15 ein erster Rohdatensatz 21 und mit der FLASH-Messsequenz 16 ein zweiter Rohdatensatz 22 erhalten werden.

Weitere übliche Bestandteile der Magnetresonanzanlage 1 wie eine Patientenliege, etc. sind der Übersichtlichkeit halber nicht dargestellt.

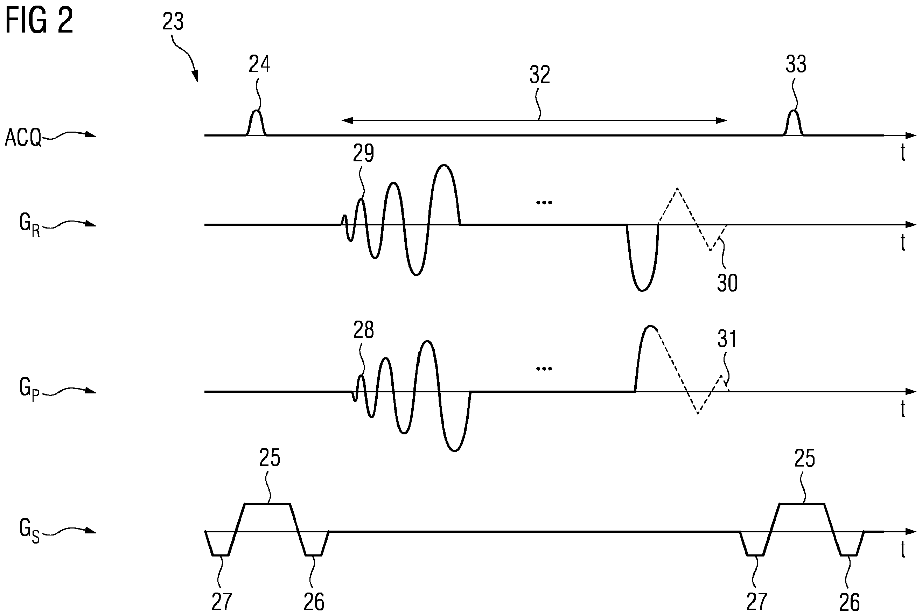

Figur 2 zeigt eine TrueFISP-Sequenzdiagramm 23 zur TrueFISP-Messsequenz 13. Die Gradientenachsen sind wie üblich mit G_{R} für die Leserichtung, G_{P} für die Phasenkodierrichtung und G_{S} für die Schichtauswahlrichtung beschriftet. ACQ bezeichnet die Achse für die Hochfrequenzimpulse und Akquisitionsfenster.

Um mit dem Hochfrequenzimpuls 24 nur eine Schicht anzuregen liegt gleichzeitig zum Hochfrequenzimpuls 24 in Schichtauswahlrichtung G_{S} ein Schichtauswahlgradient 25 an. Um dessen dephasierende Wirkung auf die Magnetisierung in der Transversalebene zu kompensieren folgt direkt auf den Schichtauswahlgradienten 25 ein Schicht-Rephasiergradient 26. Zusätzlich zu diesen Gradienten ist in Schichtauswahlrichtung G_{S} ein Schicht-Dephasiergradient 27 vorhanden. Dieser sorgt dafür, dass die TrueFISP-Messsequenz 13 über eine Repetitionszeit T_{R} "balanced" ist. D.h. es sind über eine Repetitionszeit T_{R} die Summen der Gradientenmomente in Schichtauswahlrichtung GS gleich Null.

In Phasenkodierrichtung G_{P} wird ein Phasenkodiergradient 28 verwendet. Dieser ist, wie der Lesegradient 29 in Leserichtung G_{R}, oszillierend angelegt. Diese Ausgestaltung wird verwendet, um den k-Raum spiralförmig abzutasten.

Zum Ausbalancieren der Gradientenmomente finden sich ein Lese-Rewindgradient 30 und ein Phasen-Rewindgradient 31 am Ende der oszillierend angelegten Gradienten. Diese sind zur besseren Abgrenzung vom Lesegradienten 29 und Phasenkodiergradient 28 gestrichelt dargestellt. Damit ist die TrueFISP-Messsequenz 13 über eine Repetitionszeit T_{R} "fully balanced", d.h. es sind über eine Repetitionszeit T_{R} die Summen der Gradientenmomente in allen Richtungen gleich Null.

In der Akquisitionsphase werden die Messsignale 32 aufgenommen.

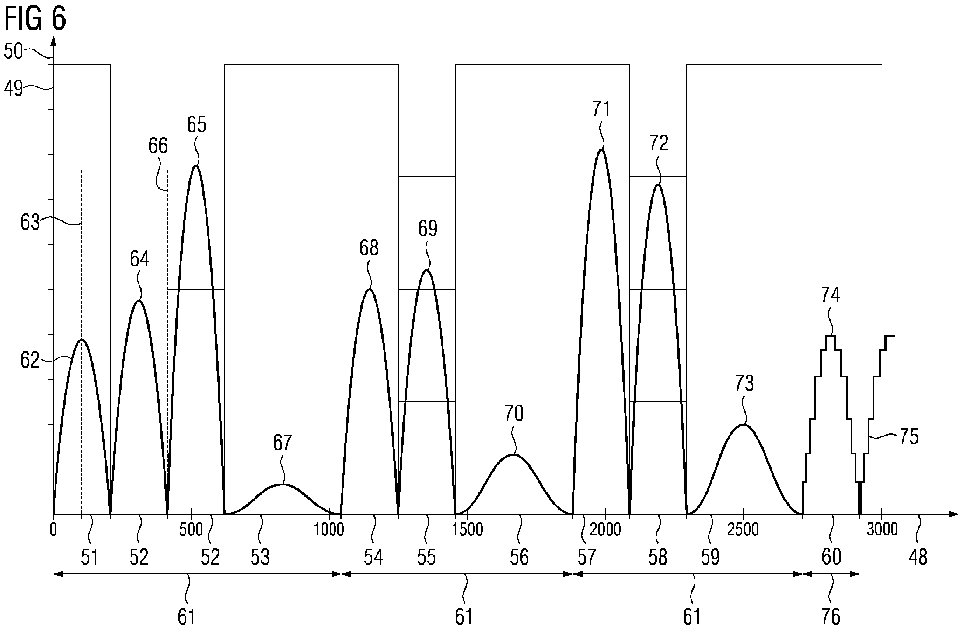

Die Aufnahme eines weiteren Rohdatensatzes wird mit dem Hochfrequenzimpuls 33 begonnen. Dieser besitzt einen anderen Flipwinkel als der vorhergehende Hochfrequenzimpuls 24. Mögliche Variationen der Flipwinkel sind in Fig. 6 dargestellt.

Bei einer FISP-Messsequenz 11 fällt im Vergleich zur TrueFISP-Messsequenz 13 zumindest der Schicht-Dephasiergradient 27 weg, ggf. auch der Lese-Rewindgradient 30. Eine FISP-Messsequenz 11 ist also nur in Phasenrichtung G_{P} ausbalanciert und evtl. in Leserichtung G_{R}, nicht jedoch in der Schichtauswahlrichtung G_{S}.

Eine FLASH-Messsequenz 12 ist im Gegensatz zu einer TrueFISP-Sequenz 13 in keiner Richtung ausbalanciert. Es fehlen dementsprechend der Schicht-Dephasiergradient 27, der Lese-Rewindgradient 30 und der Phase-Rewindgradient 31.

Aufgrund der ansonsten großen Übereinstimmungen wurde daher lediglich ein TrueFISP-Sequenzdiagramm 23 dargestellt, die Abwandlungen für eine FISP-Messsequenz 11 und eine FLASH-Messsequenz 12 ergeben sich wie beschrieben.

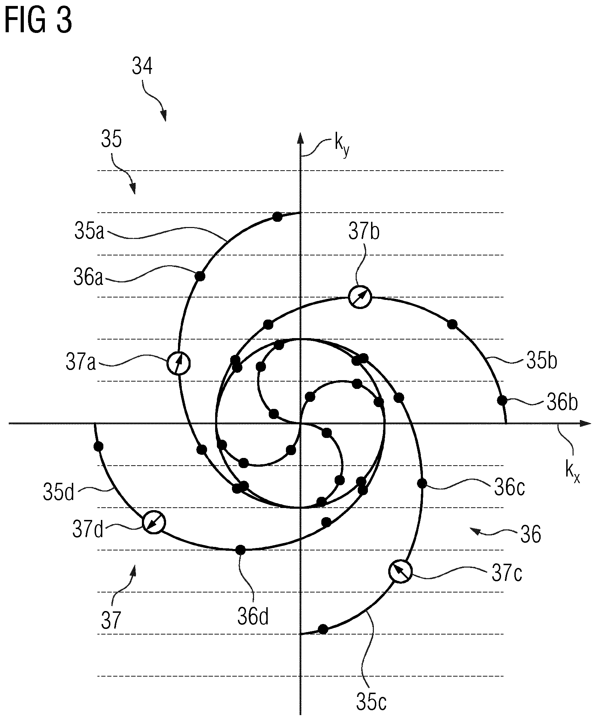

Fig. 3 zeigt einen k-Raum 34 mit einer zu den Messsequenzen 11 bis 13 gehörigen spiralförmigen k-Raum-Trajektorie 35 mit Spiralen 35a, 35b, 35c und 35d. Die vier Spiralen 35a, 35b, 35c und 35d weisen die gleiche Form auf, sind aber in 90°-Schritten gegeneinander verdreht. Dadurch ergibt sich im Zentrum eine dichtere Abtastung des k-Raums 34.

Exemplarisch sind einige Auslesepunkte 36 mit Bezugszeichen versehen, an denen Messsignale 32 aufgenommen werden. Dies ist eine bekannte bildliche Darstellung der Ortskodierung der Messsignale 32.

An vier Auslesepunkten 36 ist exemplarisch eine Phase 37a, 37b, 37c und 37d der Phasenverteilung 37 der k-Raum-Trajektorie 35 in der bekannten Uhrzeigerdarstellung eingezeichnet. Eine Phase existiert zu jedem Auslesepunkt, auch wenn nur einige angezeigt wurden. Jeder Auslesepunkt 36 weist eine eigene Phase auf.

Die Verwendung mehrerer Spiralen 35a, 35b, 35c und 35d als spiralförmige k-Raum-Trajektorie 35 ist eine mögliche Ausgestaltung einer Spiraltrajektorie.

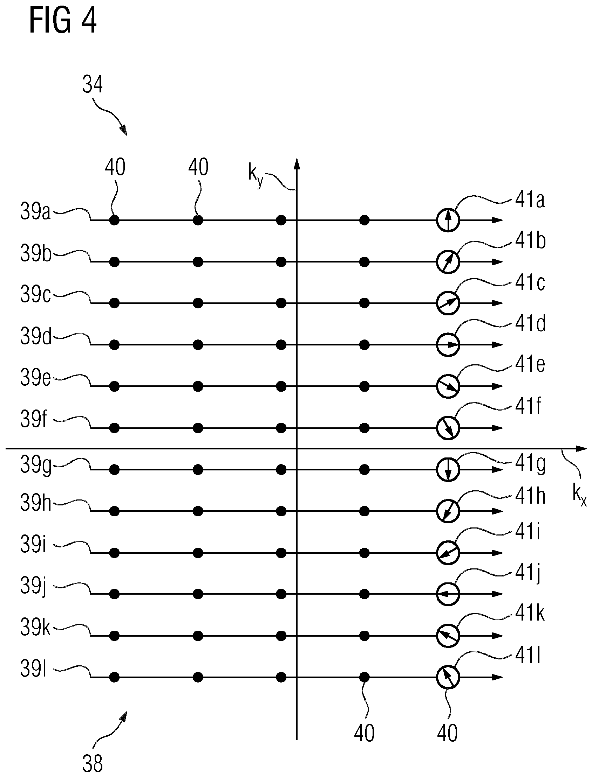

Figur 4 zeigt einen k-Raum 34 mit einer zu den Messsequenzen 14 oder 16 gehörigen k-Raum-Trajektorie 38 mit k-Raum-Zeilen 39a bis 39l. Die Auslesepunkte 40 liegen hier auf den k-Raum-Zeilen 39a bis 39l. Die k-Raum-Trajektorie 38 besteht aus einzelnen, unverbundenen k-Raum-Zeilen 39a bis 39l. Die Pfeilspitzen an den Enden der k-Raum-Zeilen sollen die Gleichheit der Ausleserichtung darstellen, haben ansonsten aber keine Bedeutung.

Die Phasen 41a bis 41l der k-Raum-Zeilen 39a bis 39l sind wieder durch eine Uhrzeigerdarstellung repräsentiert. Die Auslesepunkte 40 einer k-Raum-Zeile haben dabei immer dieselbe Phase.

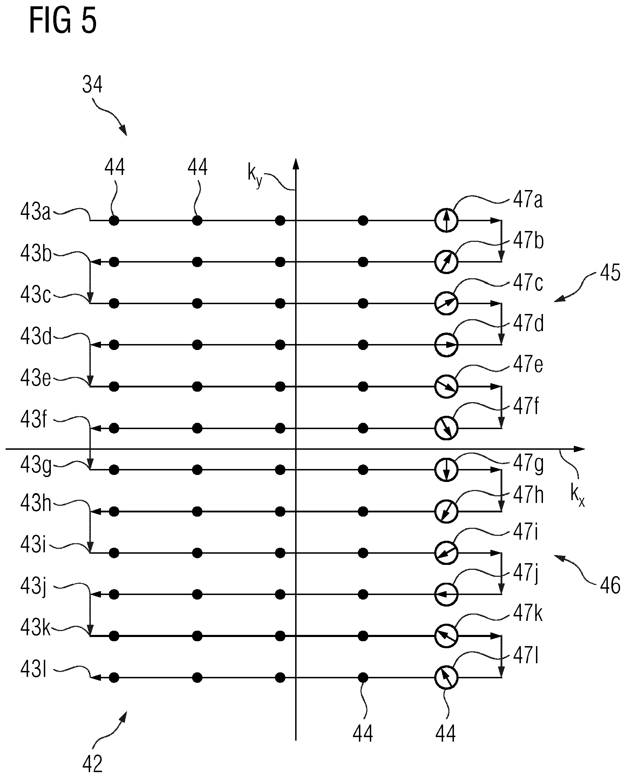

Figur 5 zeigt einen k-Raum 34 mit einer zur EPI-Messsequenz 15 gehörigen k-Raum-Trajektorie 42 mit k-Raum-Zeilen 43a bis 43l. Die Auslesepunkte 44 liegen hier auf den k-Raum-Zeilen 43a bis 43l. Die k-Raum-Trajektorie 42 besteht aus verbundenen k-Raum-Zeilen 43a bis 43f und 43g bis 43l, die in zwei Blöcken 45 und 46 angeordnet sind. Mit anderen Worten ist die Messung segmentiert. Wie weiter oben beschrieben weisen die Blöcke 45 und 46 üblicherweise mehr als zwei k-Raum-Zeilen auf. Der Übersichtlichkeit halber sind nur wenige k-Raum-Zeilen dargestellt.

Auch in Figur 5 werden die Phasen 47a bis 47l der k-Raum-Zeilen 43a bis 43l durch eine Uhrzeigerdarstellung repräsentiert. Die Auslesepunkte 44 einer k-Raum-Zeile haben dabei immer dieselbe Phase.

Wie bereits mehrmals beschrieben umfasst eine k-Raum-Trajektorie, also auch die k-Raum-Trajektorie 42, alle Messsignale 32, hier durch Auslesepunkte 44 repräsentiert, die bei der Erzeugung eines Bilddatensatzes verwendet werden. Sie beinhaltet damit beide Blöcke 45 und 46 und nicht nur einen von beiden.

Figur 6 zeigt schematisch ein Aufnahmeverfahren zur Aufnahme eines MRF-Datensatzes. Dabei sind auf der Achse 48 die Nummer des aufgenommenen MRF-Bilddatensatzes und auf der Achse 49 unterschiedliche Größen aufgetragen. Als erste Größe ist der Flipwinkel in ° von 0° beim Ursprung bis 90° beim Achsenpunkt 50 aufgetragen. Die Achse 48 läuft vom MRF-Bilddatensatz 1 bis zum MRF-Bilddatensatz 3000.

Die 3000 MRF-Bilddatensätze sind auf elf Abschnitte 51, 52, 53, 54, 55, 56, 57, 58, 59 und 60 verteilt.

Im ersten Abschnitt 51 ist über die Kurve 62 für zweihundert MRF-Bilddatensätze der Flipwinkel der FISP-Messsequenz 12 aufgetragen, der bei der Aufnahme verwendet wurde. Wie zu Figur 2 beschrieben wird nach dem Anlegen eines Hochfrequenzimpulses mit einem bestimmten Flipwinkel eine komplette Spirale aufgenommen und dann der nächste Hochfrequenzimpuls mit dem nächsten Flipwinkel angelegt und eine weitere, um 90° gedrehte Spirale abgetastet. Figur 6 zeigt in Abschnitt 51 dementsprechend eine Flipwinkelverteilung, die einer sin²-Kurve entspricht. Der maximale Flipwinkel ist 24° groß und es werden konstante Phasen verwendet.

Für den hundertsten MRF-Bilddatensatz ist rein exemplarisch eine Linie 63 eingetragen. Der korrespondierende Flipwinkel ist der maximale Flipwinkel der Kurve 62.

Im zweiten Abschnitt 52 werden vierhundert MRF-Bilddatensätze mit der TrueFISP-Sequenz 13 gemäß Figur 2 akquiriert. Dabei werden Flipwinkel gemäß der Kurven 64 und 65 eingesetzt. Bei der Kurve 64 reichen diese bis 45° und bei der Kurve 65 bis 72°.

Auch für den Abschnitt 52 ist rein exemplarisch beim vierhundertsten MRF-Bilddatensatz eine Linie 66 eingezeichnet. Hier beträgt der Flipwinkel 1°.

Eine Besonderheit stellt im Abschnitt 52 die Verwendung zweier unterschiedlicher Phasenzyklen dar. Beim Durchlaufen der Flipwinkel der Kurve 64 wird kein Phasenzyklus verwendet und beim Durchlaufen der Kurve 65 ein 180°-Phasenzyklus.

Im folgenden Abschnitt 53 sind in der Kurve 67 die Flipwinkel zur Aufnahme von vierhundertfünfzig MRF-Bilddatensätzen mit einer FLASH-Messsequenz 12 angegeben. Diese sind kleiner als in der FISP- oder TrueFISP-Messsequenz und laufen bis 6°. Auch ihre Verteilung ist eine sin²-Verteilung.

Zusätzlich zur Variation der Flipwinkel wird beim wiederholten Durchlaufen der FLASH-Sequenz ein Phasenzyklus zur Realisierung eines RF-Spoiling angelegt. Dabei wird die Phase um Vielfache von 117° erhöht.

Die Abfolge der Messsequenzen 11, 12 und 13 bilden zusammen einen Block 61. Dieser wird in Figur 6 insgesamt dreimal verwendet. Dabei wird allein auf den Typ der Messsequenz aber nicht auf die Anzahl der MRF-Bilddatensätze oder die Flipwinkelkurven abgestellt.

Im Abschnitt 54 werden wieder 200 MRF-Bilddatensätze mit einer FISP-Sequenz 11 aufgenommen. Die Phase ist wie in Abschnitt 51 konstant, aber der maximale Flipwinkel beträgt 45°. Diese liegen auf der Kurve 68.

In Abschnitt 55 folgen 200 MRF-Bilddatensätze, die mit einer TrueFISP-Messsequenz 13 zu akquirieren sind. Hier wird ein 90°-Phasenzyklus eingesetzt, der maximale Flipwinkel liegt bei 50°. Die Flipwinkel sind auf der Kurve 69 aufgetragen.

Die nächsten ca. 450 MRF-Bilddatensätze in Abschnitt 56 sind, wie in Abschnitt 53, mit einer FLASH-Messsequenz 12 aufzunehmen. Die Kurve 70 zeigt eine sin²-Verteilung mit einem Maximalwert von 14°.

Die Kurve 71 in Abschnitt 57 läuft bis 72° und zeigt die Flipwinkel des Hochfrequenzimpulses 24 bzw. 33 beim drittmaligen Verwenden einer FISP-Messsequenz 11. Auch in diesem Durchlauf ist die Phase konstant.

Beim Akquirieren weiterer zweihundert MFR-Bilddatensätze in Abschnitt 58 mit einer TrueFISP-Messsequenz 13 gemäß Figur 2 wird ein 270°-Phasenzyklus eingesetzt. Die Flipwinkel, die in der Kurve 72 aufgetragen sind, laufen bis 65°.

Die nächsten ca. 450 MRF-Bilddatensätze in Abschnitt 59 werden mit der FLASH-Messsequenz 16 aufgenommen. Die Kurve 73 stellt einen Flipwinkelverlauf bis maximal 20° dar, wiederum sin²-verteilt.

Bis zu diesem Abschnitt wurden immer Messsequenzen mit Spiraltrajektorien zur Abtastung des k-Raums verwendet. Die akquirierten Rohdatensätze sind erste Rohdatensätze. Dabei werden die auf Spiralen abgetasteten Messsignale jeweils vier aufeinanderfolgender MRF-Bilddatensätze zu einem ersten Rohdatensatz zusammengefasst. Die Anzahl der ersten Rohdatensätze ist also ein Viertel der Anzahl der MRF-Bilddatensätze.

Im Folgenden wird eine kartesische Abtastung verwendet, wie sie in Figur 4 dargestellt ist.

Im letzten Abschnitt 60 liegen zwei Kurven 74 und 75 zur Aufnahme von zweiten Rohdatensätzen mit einer FISP-Messsequenz 14. Diese stellen wiederum Flipwinkelverläufe dar. Wie bereits in den vorhergehenden Abschnitten wird bei der FISP-Messsequenz 18 eine konstante Phase verwendet. Mehrere k-Raum-Zeilen, die zur Erzeugung eines MRF-Bilddatensatzes verwendet werden, können mit demselben Flipwinkel aufgenommen sein. Ein zweiter Rohdatensatz umfasst dann, wie beim ersten Rohdatensatz, ein bestimmtes Vielfaches der mehreren k-Raum-Zeilen. Bspw. können vier k-Raum-Zeilen zur Rekonstruktion eines MRF-Bilddatensatzes verwendet werden und sechszehn, also vier mal vier, zur Rekonstruktion eines Refrenzbilddatensatzes. Dementsprechend umfasst die k-Raum-Trajektorie des zweiten Rohdatensatzes sechzehn unverbundene k-Raum-Zeilen.

Der Abschnitt mit den kartesisch abgetasteten zweiten Rohdatensätzen bildet einen Block 76.

Zusammenfassend kann man festhalten, dass, unabhängig von der konkreten Bildanzahl und den jeweils maximalen Flipwinkeln, in allen Abschnitten vorzugsweise ein sin²-verteilter Flipwinkelverlauf verwendet wird. Es können in einem Abschnitt auch erheblich weniger Bilddatensätze aufgenommen werden, bevorzugt aber wenigstens 10.

Die so aufgenommenen ersten und zweiten Rohdatensätze bilden zusammen einen MRF-Datensatz.

Es muss zwar lediglich ein einziger zweiter Rohdatensatz zur Durchführung des Verfahrens vorhanden sein. In diesem Beispiel werden mehrere zweite Rohdatensätze akquiriert, um die Kurven 74 und 75 abzutasten. Dann können die zweiten Rohdatensätze auch zur Erzeugung jeweils mehrerer MRF-Bilddatensätze verwendet werden.

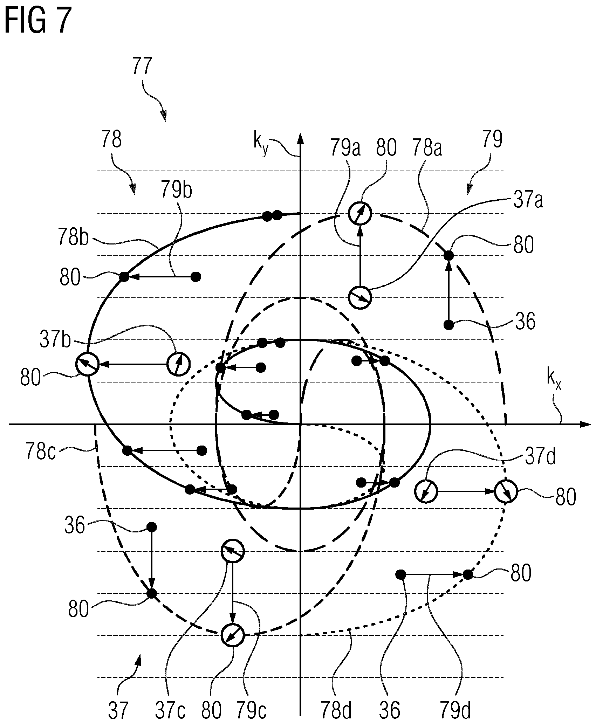

Fig. 7 zeigt einen korrigierten ersten Rohdatensatz 77 mit einer korrigierten k-Raum-Trajektorie 78. Dabei ist ein Entzerrungskoeffizientensatz 79 auf einen ersten Rohdatensatz angewendet worden. Vom Entzerrungskoeffizientensatz 79 sind exemplarisch die Verschiebevektoren 79a bis 79d mit Bezugszeichen versehen. Dadurch werden die Auslesepunkte 36 zu korrigierten Auslesepunkten 80 verschoben.

Jeder Verschiebevektor 79a bis 79d bewirkt eine örtliche Verschiebung der Auslesepunkte 36 im k-Raum 34 und/oder eine Phasenverschiebung der Phasen 37a bis 37c, wobei in Figur 7 beide Verschiebungen dargestellt sind. Er kann aber auch als Identitätsverschiebnung ausgebildet sein. Dann ändert er nichts. Sowohl der Auslesepunkt als auch die Phase sind Parameter eines einzigen Messsignals, weswegen die Entzerrung dieser Parameter auch jeweils in einem einzigen Verschiebevektor 79a bis 79d zusammengefasst werden kann.

Die Wirkung eines Entzerrungskoeffizientensatzes 79 ist exemplarisch für vier Spiralen 78a bis 78d einer spiralförmige k-Raum-Trajektorie 78 dargestellt. Bei einer spiralförmigen Abtastung kann also nicht nur eine Spirale verwendet werden, sondern auch mehrere gegeneinander versetzte oder verdrehte Spiralen. Selbstverständlich können entsprechende Verschiebevektoren und Entzerrungskoeffizientensätze 79 für beliebige k-Raum-Trajektorien verwendet werden.

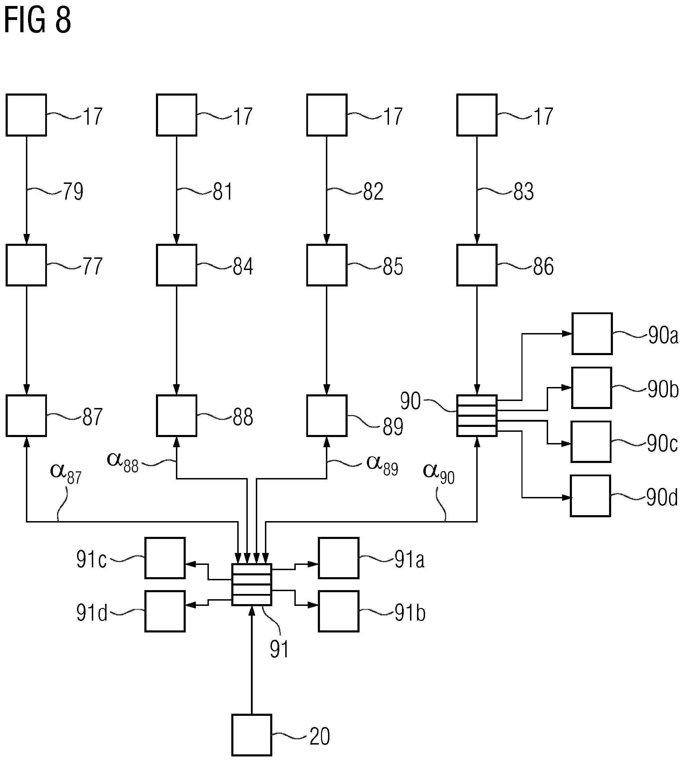

Fig. 8 zeigt eine erste Ausführungsform zur Rekonstruktion von Bilddatensätzen. Dabei werden ausgehend von einem ersten Rohdatensatz 17 durch Anwendung von Entzerrungskoeffizientensätzen 79, 81, 82 und 83 korrigierte erste Rohdatensätze 77, 84, 85 und 86 erzeugt. Aus jedem korrigierten ersten Rohdatensatz 77, 84, 85 und 86 wird ein Bilddatensatz 87, 88, 89 und 90 erzeugt.

Aus dem zweiten Rohdatensatz 20 wird ohne Änderungen ein Referenzbilddatensatz 91 erzeugt.

Die Bilddatensätze 87, 88, 89 und 90 werden mit dem Referenzbilddatensatz 91 verglichen und jeweils ein Ähnlichkeitswert α₈₇, α₈₈, α₈₉ und α₉₀ ermittelt. Derjenige Bilddatensatz mit dem größten Ähnlichkeitswert wird ausgewählt.

Ist dies bspw. der Bilddatensatz 90, und ist dieser Teil eines MRF-Datensatzes, so werden aus einzelnen Spiralen 78a bis 78d der k-Raum-Trajektorie 78 des Bilddatensatzes 90 MRF-Bilddatensätze 90a, 90b, 90c und 90d erzeugt.

Im Zusammenhang mit MR Fingerprinting kann der Referenzbilddatensatz 91 ebenfalls mit variierenden Messparametern bei der Akquisition der k-Raum-Zeilen aufgenommen sein. Dann können auch aus dem Referenzbilddatensatz 91 MRF-Bilddatensätze 91a, 91b, 91c und 91d erzeugt werden. Zu jedem der Bildelemente wird aus den MRF-Bilddatensätzen 90a, 90b, 90c, 90d, 91a, 91b, 91c und 91d eine Signalverlaufskurve erstellt und mit einem Dictionary abgeglichen. So werden für jedes Bildelement Werte für bspw. T1, T2, B0 und B1 erhalten.

Dabei sind die MRF-Bilddatensätzen 90a, 90b, 90c und 90d vierfach unterabgetastet im Vergleich zum Bilddatensatz 90 und die MRF-Bilddatensätzen 91a, 91b, 91c und 91d vierfach unterabgetastet im Vergleich zum Referenzbilddatensatz 91. Dies ist aber möglich, da die MRF-Bilddatensätzen 90a, 90b, 90c, 90d, 91a, 91b, 91c und 91d wie beschrieben zur Erstellung von Signalverlaufskurven verwendet werden und nicht zur direkten Betrachtung.

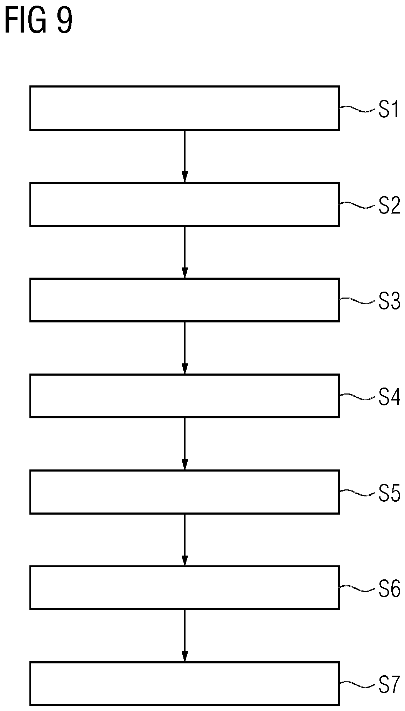

Fig. 9 zeigt ein Ablaufschema einer zweiten Ausführungsform zur Erzeugung eines Bilddatensatzes.

In Schritt S1 werden ein erster Rohdatensatz 17 und ein zweiter Rohdatensatz 20 bereitgestellt. Der erste Rohdatensatz 17 ist mit einer Spiralabtastung aufgenommen und der zweite Rohdatensatz 20 mit einer kartesischen Abtastung.

In Schritt S2 wird die k-Raum-Trajektorie des ersten Rohdatensatzes 17 unter Verwendung eines ersten Entzerrungskoeffizientensatzes 79 verschoben und aus der korrigierten k-Raum-Trajektorie 78 mittels Regridding ein kartesischer Zwischendatensatz generiert. Dieser Zwischendatensatz wird mittels Fouriertransformation zu einem ersten Bilddatensatzes 87 rekonstruiert.

Das Regridding und die Fouriertransformation sind bei der Rekonstruktion von Rohdatensätzen mit Spiraltrajektorien übliche Rekonstruktionsschritte.

Danach wird in Schritt S3 aus demselben ersten Rohdatensatz 17 ein zweiter Bilddatensatz 88 unter Verwendung eines zweiten Entzerrungskoeffizientensatzes 81 rekonstruiert.

Im folgenden Schritt S4 wird aus dem zweiten Rohdatensatz 20 ein Referenzbilddatensatz 91 rekonstruiert. Danach werden in Schritt S5 Ähnlichkeitswerte α₈₇ und α₈₈ ermittelt. Der zu dem Bilddatensatz mit dem größeren Ähnlichkeitswert gehörige Entzerrungskoeffizientensatz wird als Ausgangsbasis bei der Ermittlung eines dritten Entzerrungskoeffizientensatzes 82 verwendet. Sei der erste Entzerrungskoeffizientensatz 79 derjenige, dessen Bilddatensatz den größeren Ähnlichkeitswert aufwies. Bspw. können dann die Verschiebungsvektoren des ersten Entzerrungskoeffizientensatzes 79 einen positiven "Eintrag" bekommen und die des zweiten Entzerrungskoeffizientensatzes 81 einen negativen.

In Schritt S6 wird aus dem oben erwähnten ersten Rohdatensatz 17 ein dritter Bilddatensatz 89 unter Verwendung des dritten Entzerrungskoeffizientensatzes 82 rekonstruiert und ein Ähnlichkeitswert α₈₉ zum Referenzbilddatensatz 86 bestimmt. Je nachdem, ob der Ähnlichkeitswert α₈₉ größer oder kleiner als der bisherige beste Ähnlichkeitswert ist wird der dritte Entzerrungskoeffizientensatz 82 weiterverwendet oder der erste Entzerrungskoeffizientensatz 79.

Selbstverständlich können zu Beginn mehr als zwei Entzerrungskoeffizientensätze verwendet werden, um eine Ausgangsbasis festzulegen. Insbesondere können die anfänglichen Entzerrungskoeefizientensätze vorgegebene Vorgaben erfüllen, z.B. nur im Zentrum oder nur im Außenbereich verschieben.

Ausgehend von dieser iterativen Anpassung der Entzerrungskoeffizientensätze kann das Verfahren solange fortgeführt werden, bis ein Abbruchkriterium erfüllt ist. Dies kann ein maximaler Iterationsschritt oder das Erreichen eines vorgegebenen Ähnlichkeitswertes sein.

Das Verfahren kann bei Vorliegen nur eines ersten Rohdatensatzes dann abschließen.

Sind aber, wie zu Figur 6 gezeigt, eine Vielzahl an ersten Rohdatensätzen vorhanden, kann in Schritt S7 der Entzerrungskoeffizientensatz gespeichert werden, der zu dem Bilddatensatz mit dem größten Ähnlichkeitswert gehört. Dieser wird verwendet, um auch die anderen ersten Rohdatensätze zu entzerren und daraus MRF-Bilddatensätze zu rekonstruieren.

Als erster Rohdatensatz 17 wird dabei auf einen Rohdatensatz zurückgegriffen, der mit derselben Messsequenz aufgenommen wurde wie der zweite Rohdatensatz. Im Beispiel zu Fig. 6 war dies die FISP-Messsequenz.

## Patentansprüche

1. Verfahren zur Erzeugung wenigstens eines Bilddatensatzes (90) und eines Referenzbilddatensatzes (91) eines Untersuchungsobjektes aus wenigstens zwei Rohdatensätzen (17, 20) mit den Schritten:
- Bereitstellen eines ersten Rohdatensatzes (17), wobei der erste Rohdatensatz (17) mit einer Magnetresonanzanlage (1) aufgenommen ist und Messsignale (32) an mehreren Auslesepunkten (36, 44) im k-Raum (34) umfasst, wobei die Auslesepunkte (36, 44) auf einer ersten k-Raum-Trajektorie (35, 42) liegen,
- Bereitstellen eines zweiten Rohdatensatzes (20), wobei der zweite Rohdatensatz (20) mit derselben Magnetresonanzanlage (1) und an demselben Untersuchungsobjekt aufgenommen ist wie der erste Rohdatensatz (17) und Messsignale (32) an mehreren Auslesepunkten (40) im k-Raum (34) umfasst, wobei die Auslesepunkte (40) auf einer zweiten, von der ersten k-Raum-Trajektorie (35, 42) unterschiedlichen k-Raum-Trajektorie (38) liegen,
- Rekonstruktion mehrerer Bilddatensätzen (87, 88, 89, 90) aus dem ersten Rohdatensatz (17), wobei vor der Rekonstruktion jedes Bilddatensatzes (87, 88, 89, 90) ein eigener Entzerrungskoeffizientensatz (79, 81, 82, 83) verwendet wird, wobei ein Entzerrungskoeffizientensatz (79, 81, 82, 83) eine Verschiebung der Auslesepunkte (36) der Messsignale (32) des ersten Rohdatensatzes (17) im k-Raum (34) definiert,
- Rekonstruktion eines Referenzbilddatensatzes (91) aus dem zweiten Rohdatensatz (20),
- Vergleich der Bilddatensätze (87, 88, 89, 90) mit dem Referenzbilddatensatz (91), wobei beim Vergleich jeweils ein Ähnlichkeitswert (α₈₇, α₈₈, α₈₉, α₉₀) erzeugt wird, und
- Auswahl des Bilddatensatzes (87, 88, 89, 90) mit dem größten Ähnlichkeitswert (α₈₇, α₈₈, α₈₉, α₉₀) und Speichern des zugehörigen Entzerrungskoeffizentensatzes,
wobei die erste k-Raum-Trajektorie auf Gradientenabweichungen empfindlicher ist als die zweite k-Raumtrajektorie.

2. Verfahren nach Anspruch 1, **dadurch gekennzeichnet, dass** als erste k-Raum-Trajektorie (35) eine Trajektorie verwendet wird, bei der die Abtastung zumindest eines Teils des k-Raums unter einem zeitlich variierenden Lesegradienten erfolgt, insbesondere eine Spiraltrajektorie.

3. Verfahren nach Anspruch 1 oder 2, **dadurch gekennzeichnet, dass** als zweite k-Raum-Trajektorie (42) eine kartesische Verteilung der Auslesepunkte (44) verwendet wird.

4. Verfahren nach einem der vorangehenden Ansprüche, **dadurch gekennzeichnet, dass** bei der Erzeugung zumindest eines Entzerrungskoeffizientensatzes (79, 81, 82, 83) ein Modell der Gradientenabweichung bei der Aufnahme des ersten Rohdatensatzes (17) verwendet wird.

5. Verfahren nach einem der vorangehenden Ansprüche, **dadurch gekennzeichnet, dass** zumindest ein Entzerrungskoeffizientensatz (79, 81, 82, 83) mit Zufallszahlen erzeugt wird.

6. Verfahren nach einem der vorangehenden Ansprüche, **dadurch gekennzeichnet, dass** eine maximale Verschiebung für die Auslesepunkte der Messsignale (32) vorgegeben wird.

7. Verfahren nach einem der vorangehenden Ansprüche, **dadurch gekennzeichnet, dass** als erster Rohdatensatz (17) mehrere Teildatensätze (35a, 35b, 35c, 35d) bereitgestellt werden, wobei die Teildatensätze (35a, 35b, 35c, 35d) mit wenigstens einem unterschiedlichen Messparameter bestehend aus der Gruppe Flipwinkel des Anregungsimpulses und/oder Repetitionszeit aufgenommen sind.

8. Verfahren nach einem der vorangehenden Ansprüche, **dadurch gekennzeichnet, dass** mehrere erste Rohdatensätze (17, 18, 19), bereitgestellt werden und für einen ersten Rohdatensatz (17) ein Entzerrungskoeffizientensatz (79, 81, 82, 83) ausgewählt wird, der für alle ersten Rohdatensätze (17, 18, 19) oder für Teildatensätze (35a, 35b, 35c, 35d) der ersten Rohdatensätze (17, 18, 19) verwendet wird.

9. Verfahren nach einem der vorangehenden Ansprüche, **dadurch gekennzeichnet, dass** nach der Rekonstruktion wenigstens zweier Bilddatensätze (87, 88) aus dem ersten Rohdatensatz (17) unter Verwendung zweier unterschiedlicher Entzerrungskoeffizientensätze (79, 81) die sich ergebenden Ähnlichkeitswerte (α₈₇, α₈₈) bei der Erzeugung eines dritten Entzerrungskoeffizientensatzes (89) berücksichtigt werden.

10. Verfahren nach einem der vorangehenden Ansprüche, **dadurch gekennzeichnet, dass** der erste Rohdatensatz (17) mit einer ersten Messsequenz (11) aufgenommen ist und die Messsequenz (14) zur Aufnahme des zweiten Rohdatensatzes (20) so ausgewählt wird, dass aus den Rohdatensätzen (17, 20) rekonstruierten Bilddatensätze (87, 88, 89, 90, 91) möglichst gleiche Kontraste aufweisen.

11. Verfahren nach einem der vorangehenden Ansprüche, **dadurch gekennzeichnet, dass** ein Entzerrungskoeffizientensatz (79, 81, 82, 83) zusätzlich eine Phasenverschiebung definiert.

12. Computerprogrammprodukt (10) für eine Steuerungseinrichtung (3) zur Steuerung eines Rechners, insbesondere einer Bilderzeugungseinheit einer Magnetresonanzanlage (1), zum Durchführen eines Verfahrens gemäß einem der vorhergehenden Ansprüche.

13. Magnetresonanzanlage (1) mit einer Steuerungseinrichtung (3), **dadurch gekennzeichnet, dass** die Steuerungseinrichtung (3) zur Durchführung eines Verfahrens nach einem der Ansprüche 1 bis 11 ausgebildet ist.

## Claims

1. Method for generating at least one image data set (90) and one reference image data set (91) of an examination object from at least two raw data sets (17, 20), having the following steps:
- providing a first raw data set (17), wherein the first raw data set (17) is acquired with a magnetic resonance system (1) and comprises measurement signals (32) at a plurality of read-out points (36, 44) in the k-space (34), wherein the read-out points (36, 44) lie on a first k-space trajectory (35, 42),
- providing a second raw data set (20), wherein the second raw data set (20) is acquired with the same magnetic resonance system (1) and at the same examination object as the first raw data set (17) and comprises measurement signals (32) at a plurality of read-out points (40) in the k-space (34), wherein the read-out points (40) lie on a second k-space trajectory (38) that is different from the first k-space trajectory (35, 42),
- reconstruction of a plurality of image data sets (87, 88, 89, 90) from the first raw data set (17), wherein before the reconstruction of each image data set (87, 88, 89, 90), a separate distortion correction coefficient set (79, 81, 82, 83) is used, wherein a distortion correction coefficient set (79, 81, 82, 83) defines a shift of the read-out points (36) of the measurement signals (32) of the first raw data set (17) in the k-space (34),
- reconstruction of a reference image data set (91) from the second raw data set (20),
- comparison of the image data sets (87, 88, 89, 90) with the reference image data set (91), wherein on comparison one similarity value (α₈₇, α₈₈, α₈₉, α₉₀) respectively is generated, and
- selection of the image data set (87, 88, 89, 90) with the greatest similarity value (α₈₇, α₈₈, α₈₉, α₉₀) and storage of the associated distortion correction coefficient set, wherein the first k-space trajectory is more sensitive to gradient deviations than the second k-space trajectory.

2. Method according to claim 1, **characterised in that** a trajectory is used as the first k-space trajectory (35) in which at least some of the k-space is sampled with a read gradient that varies over time, in particular a spiral trajectory.

3. Method according to claim 1 or 2, **characterised in that** a Cartesian distribution of the read-out points (44) is used as the second k-space trajectory (42).

4. Method according to one of the preceding claims, **characterised in that** when generating at least one distortion correction coefficient set (79, 81, 82, 83), a model of the gradient deviation during acquisition of the first raw data set (17) is used.

5. Method according to one of the preceding claims, **characterised in that** at least one distortion correction coefficient set (79, 81, 82, 83) is generated with random numbers.

6. Method according to one of the preceding claims, **characterised in that** a maximum shift is specified for the read-out points of the measurement signals (32).

7. Method according to one of the preceding claims, **characterised in that** a plurality of partial data sets (35a, 35b, 35c, 35d) is provided as the first raw data set (17), wherein the partial data sets (35a, 35b, 35c, 35d) are acquired with at least one different measurement parameter comprising the group: flip angle of the excitation pulse and/or repetition time.

8. Method according to one of the preceding claims, **characterised in that** a plurality of first raw data sets (17, 18, 19) is provided and for a first raw data set (17) a distortion correction coefficient set (79, 81, 82, 83) is selected, which is used for all first raw data sets (17, 18, 19) or for partial data sets (35a, 35b, 35c, 35d) of the first raw data sets (17, 18, 19).

9. Method according to one of the preceding claims, **characterised in that** after the reconstruction of at least two image data sets (87, 88) from the first raw data set (17) using two different distortion correction coefficient sets (79, 81), the resulting similarity values (α₈₇, α8₈) are considered when generating a third distortion correction coefficient set (89).

10. Method according to one of the preceding claims, **characterised in that** the first raw data set (17) is acquired with a first measurement sequence (11) and the measurement sequence (14) for acquisition of the second raw data set (20) is selected such that image data sets (87, 88, 89, 90, 91) reconstructed from the raw data sets (17, 20) have optimally the same contrasts.

11. Method according to one of the preceding claims, **characterised in that** a distortion correction coefficient set (79, 81, 82, 83) also defines a phase shift.

12. Computer program product (10) for a control device (3) for controlling a computer, in particular an image generating unit of a magnetic resonance system (1), for carrying out a method according to one of the preceding claims.

13. Magnetic resonance system (1) with a control device (3), **characterised in that** the control device (3) is designed for carrying out a method according to one of claims 1 to 11.

## Revendications

1. Procédé de production d'au moins un ensemble (90) de données d'image et d'un ensemble (91) de données d'image de référence d'un objet à examiner à partir d'au moins deux ensembles (17, 20) de données brutes, comprenant les stades :
- on se procure un premier ensemble (17) de données brutes, dans lequel le premier ensemble (17) de données brutes est enregistré par une installation (1) de résonnance magnétique et comprend des signaux (32) de mesure en plusieurs points (36, 44) de lecture dans l'espace k (34), dans lequel les points (36, 44) de lecture sont sur une première trajectoire (35, 42) dans l'espace k,
- on se procure un deuxième ensemble (20) de données brutes, dans lequel le deuxième ensemble (20) de données brutes est enregistré par la même installation (1) de résonnance magnétique et sur le même objet à examiner que le premier ensemble (17) de données brutes et comprend des signaux (32) de mesure en plusieurs points (40) de lecture dans l'espace k (34), dans lequel les points (40) de lecture sont sur une deuxième trajectoire (38) dans l'espace k différente de la première trajectoire (35, 42) dans l'espace k,
- on reconstruit plusieurs ensembles (87, 88, 89, 90) de données d'image, à partir du premier ensemble (17) de données brutes, dans lequel, avant la reconstruction de chaque ensemble (87, 88, 89, 90) de données d'image, on utilise un ensemble (79, 81, 82, 83) de coefficients de correction propre, dans lequel un ensemble (79, 81, 82, 83) de coefficients de correction définit un décalage des points (36) de lecture des signaux (32) de mesure du premier ensemble (17) de données brutes dans l'espace k (34),
- on reconstruit un ensemble (91) de données d'image de référence, à partir du deuxième ensemble (20) de données brutes,
- on compare les ensembles (87, 88, 89, 90) de données d'image à l'ensemble (91) de données d'image de référence, dans lequel, lors de la comparaison, on produit respectivement une valeur (α₈₇, α₈₈, α₈₉, α₉₀) de similitude, et
- on choisit l'ensemble (87, 88, 89, 90) de données d'image ayant la valeur (α₈₇, α₈₈, α₈₉, α₉₀) de similitude la plus grande et on met en mémoire l'ensemble de coefficients de correction lui appartenant,
dans lequel la première trajectoire dans l'espace k est plus sensible à des écarts de gradients que la deuxième trajectoire dans l'espace k.

2. Procédé suivant la revendication 1, **caractérisé en ce que** l'on utilise, comme première trajectoire (35) dans l'espace k, une trajectoire, pour laquelle le balayage d'au moins une partie de l'espace k s'effectue avec un gradient de lecture variant dans le temps, en particulier une trajectoire en spirale.

3. Procédé suivant la revendication 1 ou 2, **caractérisé en ce que** l'on utilise, comme deuxième trajectoire (42) dans l'espace k, une distribution cartésienne des points (44) de lecture.

4. Procédé suivant l'une des revendications précédentes, **caractérisé en ce que**, lors de la production d'au moins un ensemble (79, 81, 82, 83) de coefficients de correction, on utilise un modèle de l'écart de gradients à l'enregistrement du premier ensemble (17) de données brutes.

5. Procédé suivant l'une des revendications précédentes, **caractérisé en ce qu'**on produit au moins un ensemble (79, 81, 82, 83) de coefficients de correction par des nombres aléatoires.

6. Procédé suivant l'une des revendications précédentes, **caractérisé en ce que** l'on prescrit un décalage maximum des points de lecture des signaux (32) de mesure.

7. Procédé suivant l'une des revendications précédentes, **caractérisé en ce que** l'on se procure, comme premier ensemble (17) de données brutes, plusieurs sous-ensembles (35a, 35b, 35c, 35d) de données, dans lequel les sous-ensembles (35a, 35b, 35c, 35d) de données sont enregistrés en ayant au moins un paramètre de mesure différent pris dans le groupe angle de flip de l'impulsion d'excitation et/ou temps de répétition.

8. Procédé suivant l'une des revendications précédentes, **caractérisé en ce que** l'on se procure plusieurs premiers ensembles (17, 18, 19) de données brutes et on choisit, pour un premier ensemble (17) de données brutes, un ensemble (79, 81, 82, 83) de coefficients de correction, qui est utilisé pour tous les premiers ensembles (17, 18, 19) de données brutes ou pour des sous-ensembles (35a, 35b, 35c, 35d) de données des premiers ensembles (17, 18, 19) de données brutes.

9. Procédé suivant l'une des revendications précédentes, **caractérisé en ce que**, après la reconstruction d'au moins deux ensembles (87, 88) de données d'image à partir du premier ensemble (17) de données brutes, on prend, lors de la production d'un troisième ensemble (89) de coefficients de correction, en compte les valeurs (α₈₇, α₈₈) de similitude, qui en résultent, en utilisant deux ensembles (79, 81) de coefficients de correction différents.

10. Procédé suivant l'une des revendications précédentes, **caractérisé en ce que** l'on enregistre le premier ensemble (17) de données brutes par une première séquence (11) de mesure, et on choisit la séquence (14) de mesure pour l'enregistrement du deuxième ensemble (20) de données brutes, de manière à ce que des ensembles (87, 88, 89, 90, 91) de données d'image reconstruits à partir des ensembles (17, 20) de données brutes aient autant que possible les mêmes contrastes.

11. Procédé suivant l'une des revendications précédentes, **caractérisé en ce qu'**un ensemble (79, 81, 82, 83) de coefficients de correction définit en outre un déphasage.

12. Produit (10) de programme d'ordinateur pour un dispositif (3) de commande pour la commande d'un ordinateur, en particulier d'une unité de production d'image d'une installation (1) de résonnance magnétique pour effectuer un procédé suivant l'une des revendications précédentes.

13. Installation (1) de résonnance magnétique ayant un dispositif (3) de commande, **caractérisée en ce que** le dispositif (3) de commande est constitué pour effectuer un procédé suivant l'une des revendications 1 à 11.
